# EUROPEAN PATENT APPLICATION

(11) **EP 4 559 717 A1**
(43) Date of publication of application: **28.05.2025**
(21) Application number: 23211675.6
(22) Date of filing: 23.11.2023
(51) Int. Cl.: B60L 3/00, B60L 58/21, G01R 31/396, G01R 31/52

(54) **ISOLATION DIAGNOSTICS OF ELECTRICAL ENERGY STORAGE PACKS WHILE UNDER LOAD**

(71) Applicant: VOLVO TRUCK CORPORATION, 405 08 Göteborg (SE)
(72) Inventor: RAY, Dripta, SE-412 76 GÖTEBORG (SE); JALTARE, Kedar, SE-413 20 GÖTEBORG (SE)
(74) Representative: Kransell & Wennborg KB

(57) **Abstract**

A computer system (106) comprising processing circuitry (108) configured to: detect an isolation fault of an electrical energy storage system (102) comprising multiple electrical energy storage packs (104) connectable to a voltage bus (110) for providing power to an electric load (112); determine a subset (124) of at least one of electrical energy storage pack that can be disconnected from the voltage bus (110) without violating present power requirements for the electric load, wherein the following steps are repeated for each subset of at least one electrical energy storage pack until an isolation fault is detected in an electrical energy storage pack (104) of the electrical energy storage system (102), or until all subsets of at least one electrical energy storage pack have been tested: disconnect a present subset of at least one electrical energy storage pack from the voltage bus; perform isolation fault check on the disconnected subset of at least one electrical energy storage packs while the other subsets of at least one electrical energy storage pack remain connected to the voltage bus, and provide a control message indicating the outcome of the isolation fault test.

## Description

### TECHNICAL FIELD

The disclosure relates generally to electrical energy storage systems. In particular aspects, the disclosure relates to isolation diagnostics of electrical energy storage packs while under load. The disclosure can be applied to heavy-duty vehicles, such as trucks, buses, construction equipment, and marine vessels, among other vehicle types as well as stationary applications. Although the disclosure may be described with respect to a particular vehicle, the disclosure is not restricted to any particular vehicle.

### BACKGROUND

Battery packs that provide electrical energy in a vehicle, machine, or a stationary installation need to be monitored for isolation resistance failures. The monitoring is a self-diagnostic check done by the electronic control system on board the battery pack to check if the chassis of the battery is shorted to either of the poles. An electrical short circuit may be caused for example by internal displacement of electrical/electronic components in the battery pack, or due to leakage of coolant or water ingress into the battery housing.

Electrical shorts in a battery may lead to a hazardous situation and improvements in monitoring batteries for such faults is desirable.

### SUMMARY

According to a first aspect of the disclosure, there is provided a computer system comprising processing circuitry configured to: detect an isolation fault of an electrical energy storage system comprising multiple electrical energy storage packs connectable to a voltage bus for providing power to an electric load; determine a subset of at least one of electrical energy storage pack that can be disconnected from the voltage bus without violating present power requirements for the electric load, wherein the following steps are repeated for each subset of at least one electrical energy storage pack until an isolation fault is detected in an electrical energy storage pack of the electrical energy storage system, or until all subsets of at least one electrical energy storage pack have been tested: disconnect a present subset of the electrical energy storage packs from the voltage bus; perform isolation fault check on the disconnected subset of at least one electrical energy storage pack while the other subsets of electrical energy storage packs remain connected to the voltage bus, and provide a control message indicating the outcome of the isolation fault test.

The first aspect of the disclosure may seek to perform isolation fault testing of electrical energy storage packs without interrupting the operation of the load. In other words, the load can still receive sufficient energy from the electrical energy storage system to maintain operation while one or more electrical energy storage packs are being tested for isolation faults. A technical benefit may include improved availability of the electrical energy storage system, that is, with fewer operation interruptions due to isolation fault testing.

It should be understood that the inventive method may either proceed until all electrical energy storage packs have been tested, whereby the one or more electrical energy storage packs with detected isolation faults are indicated in the control messages. In this way, multiple faulty electrical energy storage packs may be identified. However, in other possible implementation, the method may end once a single electrical energy storage pack with an isolation fault is detected.

Optionally in some examples, including in at least one preferred example, the processing circuitry may be further configured to: determine an electrical energy storage state for each of the subsets, and determine the order of disconnecting the subsets based on the determined electrical energy storage states. A technical benefit may include more efficient fault testing by a prioritized order of testing the subsets. In this way, a selective disconnection order may provide for testing more critical subsets first, or for maintaining certain subsets connected that ensures sufficient energy is provided to the load for a given time duration.

Optionally in some examples, including in at least one preferred example, the electrical energy storage state may be one of state of charge and state of health. That is, available energy and/or the aging status of the subsets may be used for determining the order of disconnecting the subsets.

Optionally in some examples, including in at least one preferred example, the processing circuitry may be further configured to: disconnect the subsets in the order of falling amount of available energy in the subsets determined from the electrical energy storage state. A technical benefit is that the subsets with highest amount of energy is quickly reconnected to ensure maintained operation of the load.

Optionally in some examples, including in at least one preferred example, the processing circuitry is further configured to: if an isolation fault is detected in one electrical energy storage pack of the one subset of at least one electrical energy storage pack, setting the one electrical energy storage pack in an error state, if no isolation fault is detected in the one electrical energy storage pack of the subset, re-connecting the one electrical energy storage pack to the voltage bus. In this way, the electrical energy storage system may be reconfigured as soon as a faulty subset of at least one electrical energy storage pack is found. That is, the electrical energy storage system may continue operation but using a reduced number of electrical energy storage packs. As soon as an electrical energy storage pack with no fault is identified, it can be reconnected to the voltage bus. However, a faulty electrical energy storage pack will remain disconnected from the voltage bus and is instead set in an error state.

Optionally in some examples, including in at least one preferred example, the processing circuitry may be further configured to: disconnect the present subset from the voltage bus and perform isolation fault tests while the remaining electrical energy storage packs provide energy/power to the electric load.

Preferably, the subset comprises more than one electrical energy storage pack. This provides for faster testing of all the electrical energy storage packs of the electrical energy storage system.

Optionally in some examples, including in at least one preferred example, the processing circuitry may be configured to: determine an electrical energy storage state for each multiple of the subsets of electrical energy storage packs; determine the order of disconnecting the subsets of electrical energy storage packs based on the relative magnitude of the electrical energy storage states, wherein the following steps are repeated for the subsets of electrical energy storage packs in the determined order: disconnecting one of the subsets of electrical energy storage packs from the voltage bus; perform isolation check on the disconnected subset of electrical energy storage packs while the other subsets of electrical energy storage packs are connected to the voltage bus; if an isolation fault is detected in the one electrical energy storage pack, setting the of electrical energy storage pack in an error state, if no isolation fault is detected in the one electrical energy storage pack, re-connecting the one electrical energy storage pack to the voltage bus.

There is further provided an electrical energy storage system comprising the computer system.

Furthermore, there is provided a vehicle comprising the electrical energy storage system.

According to a second aspect of the disclosure, there is provided a computer-implemented method, comprising: detecting, by processing circuitry of a computer system, an isolation fault of an electrical energy storage system comprising multiple electrical energy storage packs connectable to a voltage bus for providing power to an electric load; determining, by the processing circuitry, a subset of at least one of electrical energy storage pack that can be disconnected from the voltage bus without violating present power requirements or need for the electric load, wherein the following steps are repeated for each subset of at least one electrical energy storage pack until an isolation fault is detected in an electrical energy storage pack of the electrical energy storage system, or until all subsets of at least one electrical energy storage pack have been tested: disconnecting, by the processing circuitry, a present subset of at least one electrical energy storage packs from the voltage bus; performing, by the processing circuitry, isolation fault check on the disconnected subset of at least one electrical energy storage pack while the other subsets of at least one electrical energy storage pack remain connected to the voltage bus, providing, by the processing circuitry, a control message indicating the outcome of the isolation fault test.

The second aspect of the disclosure may seek to perform isolation fault testing of electrical energy storage packs without interruption operation of the load. In other words, the load can still receive sufficient energy from the electrical energy storage system to maintain operation while one or more electrical energy storage packs are being tested for isolation faults. A technical benefit may include improved availability of the electrical energy storage system, that is, with fewer operation interruptions due to isolation fault testing.

Optionally in some examples, including in at least one preferred example, the method may comprise determining, by the processing circuitry, an electrical energy storage state for each of the subsets, and determining, by the processing circuitry, the order of disconnecting the subsets based on the determined electrical energy storage states.

Optionally in some examples, including in at least one preferred example, the method may comprise disconnecting, by the processing circuitry, the subsets in the order of falling state of charge.

Optionally in some examples, including in at least one preferred example, the method may comprise detecting, by the processing circuitry, an isolation fault in one electrical energy storage pack of the present subset, and setting, by the processing circuitry, the one electrical energy storage pack in an error state.

Optionally in some examples, including in at least one preferred example, the method may comprise determining, by the processing circuitry, that no isolation fault is detected in the one electrical energy storage pack of the one subset, and re-connecting, by the processing circuitry, the one electrical energy storage pack to the voltage bus.

Optionally in some examples, including in at least one preferred example, the method may comprise disconnecting, by the processing circuitry, the present subset from the voltage bus and perform isolation fault tests while the remaining electrical energy storage packs provide energy/power to the electric load.

Optionally in some examples, including in at least one preferred example, the subset comprises more than one electrical energy storage pack.

Optionally in some examples, including in at least one preferred example, the method may comprise determining, by the processing circuitry, an electrical energy storage state for each multiple of the subsets of electrical energy storage packs; determining, by the processing circuitry, the order of disconnecting the subsets of electrical energy storage packs based on the relative magnitude of the electrical energy storage states, wherein the following steps are repeated for the subsets of at least one electrical energy storage pack in the determined order: disconnecting, by the processing circuitry, one of the subsets of electrical energy storage packs from the voltage bus; performing, by the processing circuitry, an isolation check on the disconnected subset of at least one electrical energy storage pack while the other subsets of at least one electrical energy storage packs remain connected to the voltage bus; if an isolation fault is detected in the one electrical energy storage pack, setting, by the processing circuitry, the one electrical energy storage pack in an error state, if no isolation fault is detected in the one electrical energy storage pack, re-connecting, by the processing circuitry, the one electrical energy storage pack to the voltage bus.

Optionally in some examples, including in at least one preferred example, detect an isolation fault of an electrical energy storage system may comprise: determining, by the processing circuitry, an isolation level to a traction system for the electrical energy storage system, determine that an isolation fault is present based on the isolation level. In an electric vehicle, this test is typically done by the traction voltage monitoring system and determines that there is an isolation fault somewhere in the electrical energy storage system without pointing out where the fault is.

There is further provided a computer program product comprising program code for performing, when executed by the processing circuitry, the method of any of the second aspect.

There is further provided a non-transitory computer-readable storage medium comprising instructions, which when executed by the processing circuitry, cause the processing circuitry to perform the method of any of the second aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary vehicle.
**FIG. 2** is an example system diagram of a computer system and an electrical energy storage system connected to a voltage bus according to an example.
**FIG. 3A** is a flow chart of an exemplary method according to examples.
**FIG. 3B** is a flow chart of an additional steps exemplary method according to examples.
FIG. 4A-G illustrates an example sequence of isolation fault testing an electrical energy storage system.
**FIG. 5** is another view of **FIG. 1**, according to an example.
**FIG. 6** is a flow chart of an exemplary method according to an example.
**FIG. 7** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

In electrical energy storage systems, it is important to monitor its status so that faults such that isolation faults can be detected. An isolation fault may lead to short circuit and potentially fire in the electrical energy storage system. With prior art solutions the entire electrical energy storage system comprising multiple electrical energy storage packs must be disconnected from the load when testing the system for isolation fault. While the electrical energy storage system is disconnected the electrical energy storage system is diagnosed for isolation faults. However, this means that the electrical energy storage system cannot be used at all during the time of the diagnosis. This drawback with prior art is addressed with the herein disclosed embodiments that will now be described in more detail.

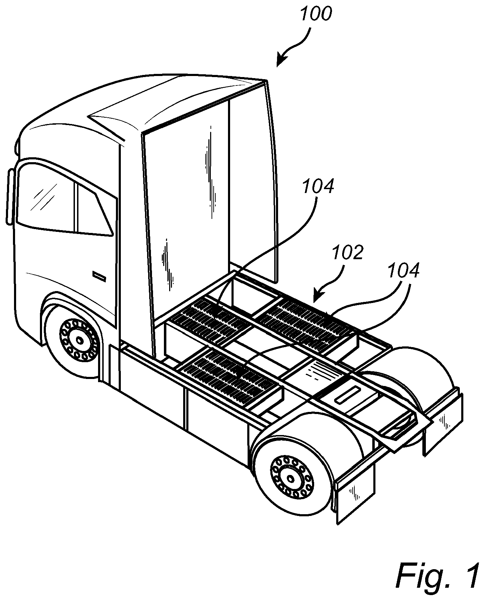

**FIG. 1** is an example vehicle 100 according to embodiments of the present disclosure. The vehicle 100 is here shown as a heavy-duty truck but other types of vehicles are also applicable. The vehicle 100 comprises a hybrid-, or fully electric driveline that is powered by an electrical energy storage system 102 comprising multiple parallel connected electrical energy storage packs 104. The electrical energy storage packs 104 comprises a plurality of electrical energy storage cells.

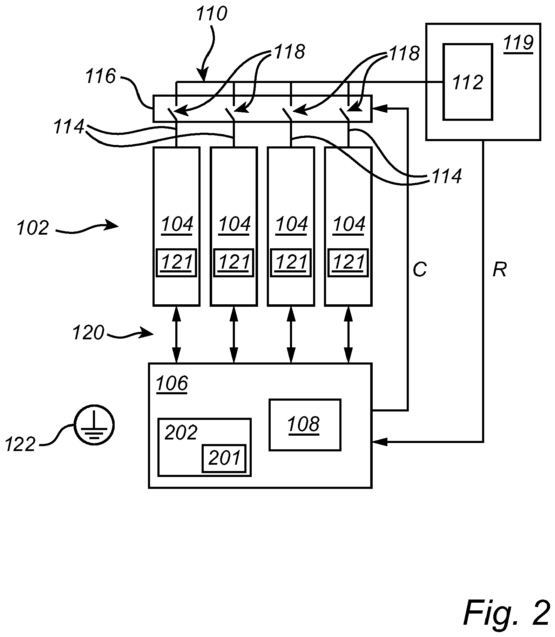

**FIG. 2** is an exemplary system diagram of a computer system 106 comprising processing circuitry 108 according to an example.

The processing circuitry 108 is electrically connected for control and communication with an electrical energy storage system 102 comprising multiple parallel connected electrical energy storage packs 104. The electrical energy storage packs 104 are electrically connected in parallel to a voltage bus 110 for providing power to an electric load 112.

Energy outputs ports 114 of the electrical energy storage packs 104 are connected to a switching circuitry 116 comprising one switch 118 for each electrical energy storage pack 104. The switches 118 which may be provided as contactors are individually controllable by the processing circuitry 108 which may control the state of the switches by sending control messages C. The state of the switches 118 are open in which open state the respective electrical energy storage pack 104 is not connected to the voltage bus 110 and closed in which closed state the of the respective electrical energy storage pack 104 is connected to the voltage bus 110 and can provide energy to the electrical load 112 via the voltage bus 110. The electrical energy storage packs are connected in parallel to the voltage bus 110 via the switches 118.

The processing circuitry 108 is further connected to a control system 119 of the electrical load 112, or to the load 112 itself so that the processing circuitry 108 may receive control message R indicating the present power requirements or need for the electric load 112, or data from which the present power requirements or need may be calculated. That is, the processing circuitry 108 may constantly have information of the amount of power or energy that the electric load 112 is presently requiring in order to fulfill a present demand of power or energy.

The processing circuitry 108 is connected to the electrical energy storage packs 104 by an electrical connection interface 120 which provides for the processing circuitry 108 to receive measurement data from sensors 121 that measure for example cell/pack voltage, electrical current, temperature, and isolation measurements such as impedance or resistance from any one of the electrical energy storage packs 104 to ground 122 such as the chassis of a vehicle 100. This provides for the processing circuitry 108 to perform isolation fault check of electrical energy storage packs 104 when they are disconnected from the voltage bus 110. Performing isolation fault check is typically done by measuring the resistance from the electrical energy storage pack 104 to ground 122. In some implementations a low resistance may be an indication of an isolation fault. However, Isolation fault testing is known *per se* to a skilled person.

The processing circuitry 108 may determine for example state of charge and state of health of the electrical energy storage packs 104 based on measurements from the sensors 121 of the electrical energy storage packs 104. State of charge, SOC, which is mentioned herein is the present level of charge in the electrical energy storage system compared to its full capacity and may be given as a percentage value.

State of health, SOH, may be defined as the loss in capacity relative to a capacity at the beginning of life of the electrical energy storage pack, or the internal resistance increase of the electrical energy storage pack relative the internal resistance at the beginning of life of the electrical energy storage pack.

State of health parameters that may be measured for determining a state of health may include at least a state of capacity, a state of resistance, and/or state of power of the electrical energy storage pack. These state of health parameters are well established and advantageously relatively straight-forward to measure and are typically available electrical energy storage pack management systems (BMS), especially in the automotive industry.

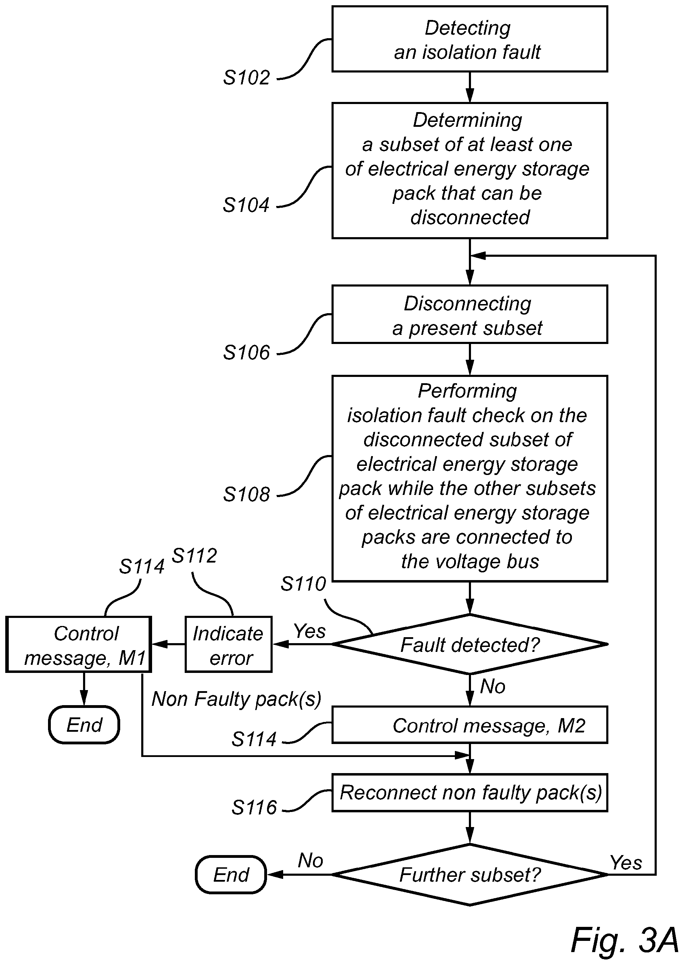

**FIG. 3A** is a flow-chart of a computer-implemented method to perform isolation fault testing of an electrical energy storage system 102.

In step S102, detecting, by processing circuitry 108 of a computer system 106, an isolation fault of an electrical energy storage system 102 comprising multiple electrical energy storage packs 104 connectable to a voltage bus 110 for providing power to an electric load 112. In this step, it is only determined that a fault is present somewhere in the system without identifying where the fault is. In embodiments, the electric load 112 is an electric propulsion engine for a vehicle 100. In such case, the precondition test, i.e., check for presence of an isolation fault somewhere in the system 102, is typically done by the traction voltage monitoring system of the electric vehicle 100.

In step S104, determining, by the processing circuitry 108, a subset of at least one of electrical energy storage pack 104 that can be disconnected from the voltage bus 110 without violating present power requirements for the electric load 112. The processing circuitry 108 may evaluate the power ability for each of the electrical energy storage packs 104 and compare that to the present requirements of the electric load 112. From the comparison can the processing circuitry 108 determine which one or more electrical energy storage packs 104 that can be disconnected from the voltage but and still fulfill the power and/or energy requirements of the electric load 112.

A subset of electrical energy storage packs 104 may be a single electrical energy storage pack 104 or, in preferred embodiment and if the power and/or energy requirements of the load allow, the subset comprises more than one electrical energy storage pack 104.

In step S106, disconnecting, by the processing circuitry 108 controlling the contactors 118, a present subset of the electrical energy storage packs 104 from the voltage bus 110.

In step S108, performing, by the processing circuitry 108, isolation fault checks on the disconnected subset of at least one electrical energy storage pack 104 while the other subsets of at least one electrical energy storage packs 104 remain connected to the voltage bus 110. In other words, the subsets are disconnected from the voltage bus 110 and the isolation fault tests are performed while the remaining electrical energy storage packs provide energy/power to the electric load 112 via the bus. Thus, the operation of the electric load 112 is not interrupted.

An isolation fault relates to there being a breakdown of insulation between an electrical pole of an electrical energy storage pack and ground (could be chassis of the vehicle). Specific electrical circuitry is employed to perform an isolation check. A known, typically high resistance is placed between the pole and the ground. The resulting potential difference across the known resistance is measured by the circuitry and then used to estimate the isolation value and determine whether an isolation fault is present.

The outcome of the isolation fault testing is next evaluated.

In step S 110, an isolation fault may be detected by the processing circuitry 108, in the one subset of at least one electrical energy storage pack 104. That is, a fault is detected in an electrical energy storage pack 104 among the presently disconnected subset of at least one electrical energy storage pack.

In such case, setting, by the processing circuitry 108, the one electrical energy storage pack in an error state in step S112. Further, the processing circuitry 108 provides a control message M1 indicating the outcome of the isolation fault test in step S114. In this case the control message M1 indicates that an isolation fault is detected and optionally in which electrical energy storage pack 104 the fault was detected.

If, however, the processing circuitry 108 determines that no isolation fault is detected in the one subset of electrical energy storage packs in step S110, the processing circuitry re-connects, in step S116, the one subset of electrical energy storage packs 104 to the voltage bus 110.

In this case the control message M2 indicates that an isolation fault is not detected in step S114.

If an isolation fault was detected in step S 110, an isolation fault is indicated in step S112, and the control message M1 thereof is provided, there are two possible ways the method proceeds. On option is that the method may be ended once an isolation fault is detected in one of the electrical energy storage packs of the present subset. In such case, the isolation fault may be severe enough so that additionally testing is not necessary. However, preferred implementations, the one or more electrical energy storage pack of the subset that do not have a confirmed isolation fault are reconnected in step S116 to the voltage bus 110.

If, subsequent to step S116, all electrical energy storage packs 104 have been tested, the method is ended, thus there are no more subsets to be tested. However, if not all electrical energy storage packs 104 have been tested, the method returns to step S106. In other words, the method starting from step S106, is repeated for each subset of at least one electrical energy storage pack until an isolation fault is detected in an electrical energy storage pack of the electrical energy storage system, or until all subsets of at least one electrical energy storage pack have been tested.

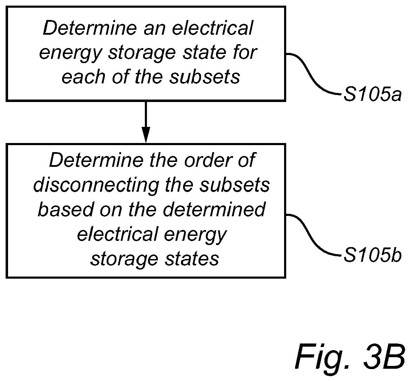

**FIG. 3B** illustrates method steps according to one example embodiment. The steps S105a and S105b are performed prior to the disconnecting step S106 in fig. 3A.

In step S105a, determining, by the processing circuitry 108, an electrical energy storage state for each of the subsets. The electrical energy storage state may be one of state of charge and state of health of the electrical energy storage packs 104 of the subset.

In step S105b, determining, by the processing circuitry 108, the order of disconnecting the subsets based on the determined electrical energy storage states. For example, the processing circuitry 108 may disconnect the subsets in the order of falling available amount of available energy, such as falling state of charge or falling state of health.

In one example, determining, by the processing circuitry, an electrical energy storage state for each multiple of the subsets of electrical energy storage packs; determining, by the processing circuitry, the order of disconnecting the subsets of electrical energy storage packs based on the relative magnitude of the electrical energy storage states, wherein the following steps are repeated for the subsets of electrical energy storage packs in the determined order: disconnecting, by the processing circuitry, one of the subsets of at least one electrical energy storage pack from the voltage bus; performing, by the processing circuitry, an isolation check on the disconnected subset of electrical energy storage packs while the other subsets of electrical energy storage packs are connected to the voltage bus; if an isolation fault is detected in the one electrical energy storage pack, setting, by the processing circuitry, the one electrical energy storage pack in an error state, if no isolation fault is detected in the one electrical energy storage pack, re-connecting, by the processing circuitry, the electrical energy storage pack to the voltage bus.

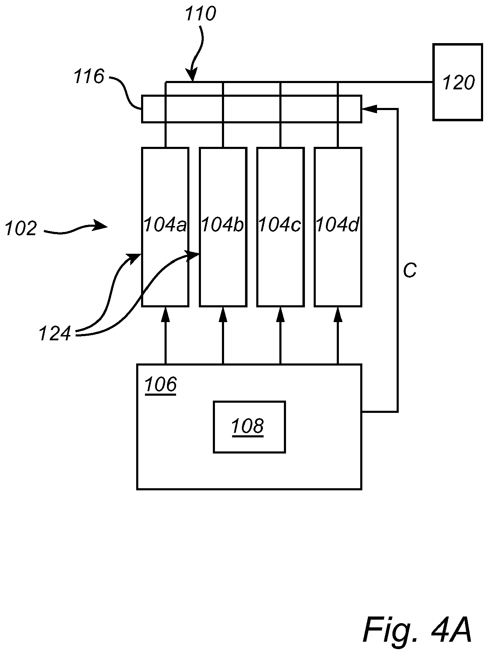

FIG. 4A-G illustrates a schematic sequence of testing the electrical energy storage system 102 comprising electrical energy storage packs 104a-d connected in parallel to the voltage bus, such as a high voltage bus of a traction system of a vehicle 100.

In **FIG. 4A**, all the electrical energy storage packs 104a-d are connected to the voltage bus 110.

If an isolation fault somewhere in the system 102 is first detected, step S102, the processing circuitry 108 determines a subset 124 of electrical energy storage pack 104a-b that can be disconnected from the voltage bus 110. It may be that the SOC or SOH of the remaining electrical energy storage packs 104c-d is sufficient to provide the load 112 with its present requirement or demanded power, but no more electrical energy storage packs can be disconnected. That is, the largest amount electrical energy storage packs that can be disconnected but still fulfill the requirement is in this case two.

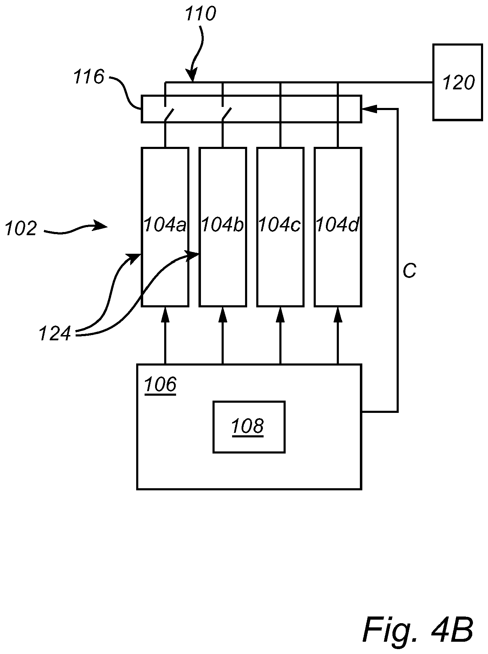

In **FIG. 4B**, the subset 124 has been disconnected, by the processing circuitry, from the voltage bus 110. The other electrical energy storage packs 104c-d remain connected to the voltage bus 110.

The processing circuitry 108 performs isolation fault testing on the disconnected subset 124, and if an isolation fault is detected, the electrical energy storage pack 104 with the isolation fault is set in error state and is not reconnected to the voltage bus. In this example, the electrical energy storage pack 104a is confirmed with an isolation fault and is not reconnected with the voltage bus 110.

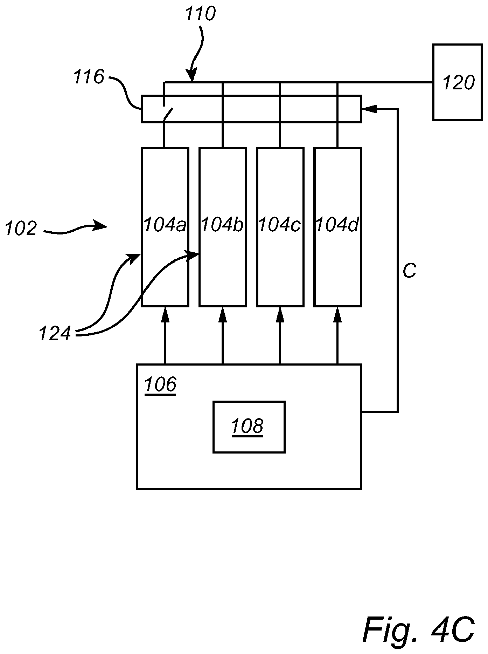

However, is no isolation fault is detected in the one or more of the packs of the subset 124, the electrical energy storage packs 104a-b with no fault is re-connected to the voltage bus 110 as illustrated in **FIG. 4C****.** Thus, electrical energy storage pack 104a with an isolation fault will therefore not be reconnected to the voltage bus 110, but the electrical energy storage pack 104b with no isolation fault is reconnected to the voltage bus 110.

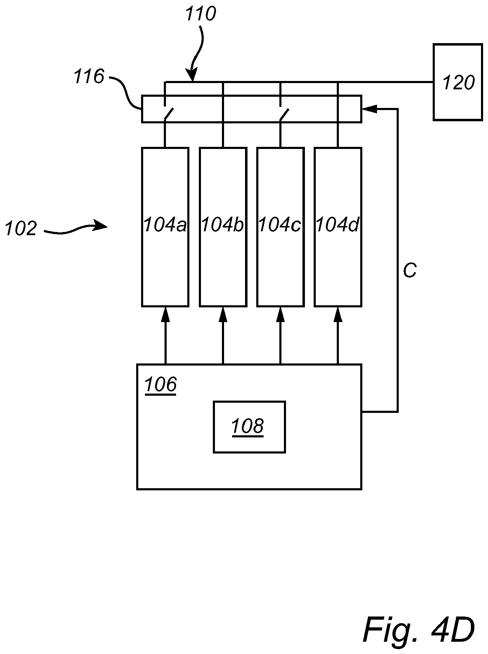

Since not all electrical energy storage packs have been tested, the processing circuitry disconnects a further subset, in fig. **FIG. 4D** being illustrated as the single electrical energy storage pack 104c. It may be the case that the reconnected and already tested electrical energy storage pack 104b is not sufficient to fulfill the present requirements of the electric load 112, thus, only the single electrical energy storage pack 104c can be disconnected.

The processing circuitry 108 performs isolation fault testing on the disconnected electrical energy storage pack 104c, and if an isolation fault is detected, the electrical energy storage pack 104c is set in error state and is not reconnected to the voltage bus 110.

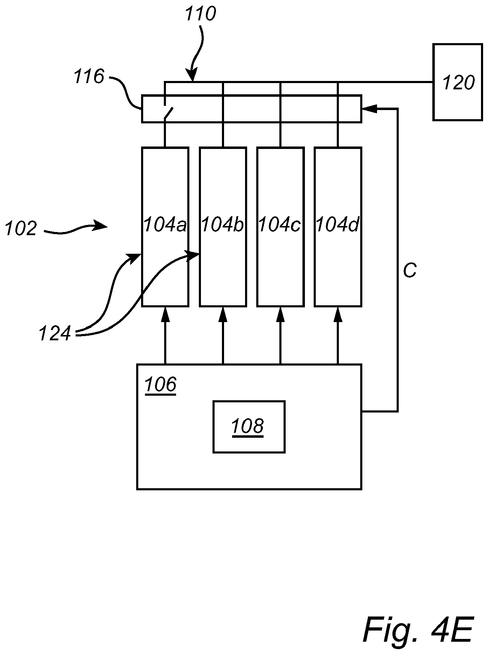

However, if no isolation fault is detected in the electrical energy storage pack 104c, the electrical energy storage pack 104c is re-connected to the voltage bus 110 as illustrated in **FIG. 4E****.**

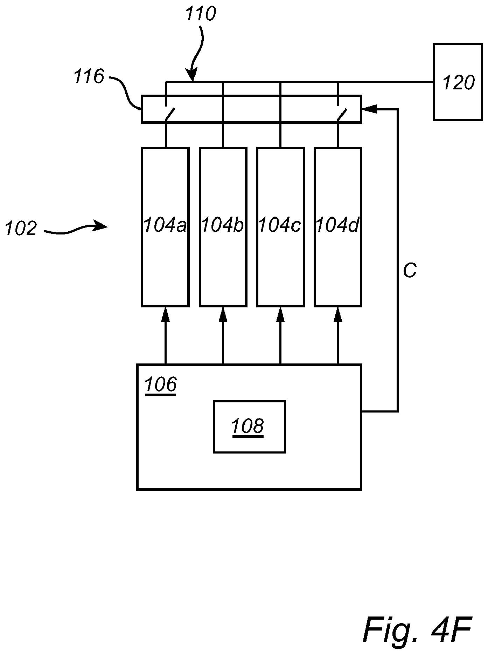

Again, since not all electrical energy storage packs have been tested, the processing circuitry disconnects a further subset, in fig. **FIG. 4F** being illustrated as the single and last electrical energy storage pack 104d.

The processing circuitry 108 performs isolation fault testing on the disconnected subset 104d, and if an isolation fault is detected in the electrical energy storage pack 104d, the electrical energy storage pack 104d is set in error state and is not reconnected to the voltage bus 110.

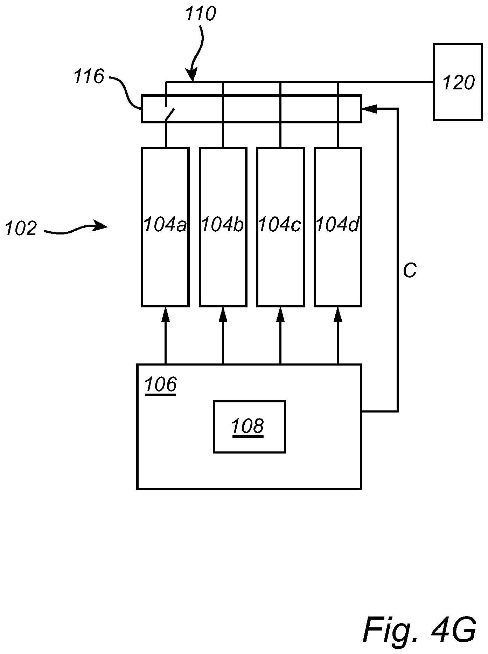

However, is no isolation fault is detected in the electrical energy storage pack 104d, the electrical energy storage pack 104d is re-connected to the voltage bus 110 as illustrated in **FIG. 4G****.**

Now, all electrical energy storage packs 104a-d have been tested and operation of the tested electrical energy storage system 102 may proceed with the faulty electrical energy storage pack 104a disconnected from the voltage bus 110 until suitable service or replacement can be provided. The confirmed electrical energy storage pack 104a with an isolation fault, thus set in error state, cannot be reconnected until the fault is confirmed to have been resolved.

There is further provided a computer program product 201 comprising program code for performing the herein described method, when executed by the processing circuitry 108. The computer program product 201 may be stored in a non-transitory computer-readable storage medium 202.

A non-transitory computer-readable storage medium 202 comprising instructions, which when executed by the processing circuitry, cause the processing circuitry to perform the method of any of claims 11-20.

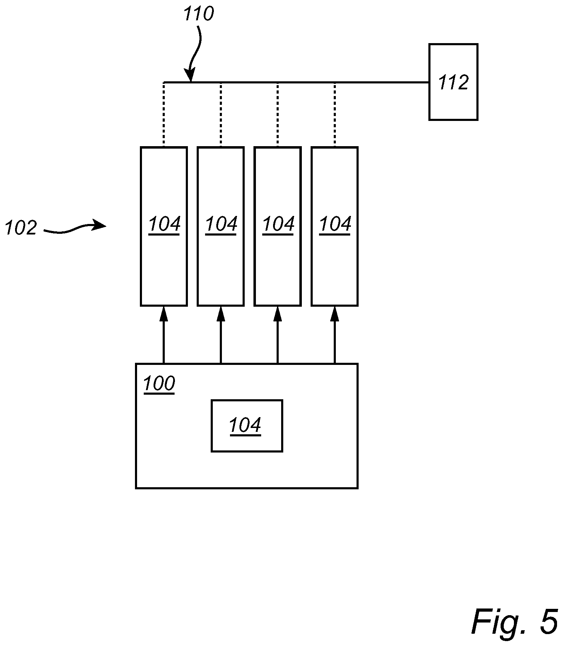

**FIG. 5** is another view of **FIG. 1**, according to an example. A computer system 106 comprising processing circuitry 108 configured to: detect an isolation fault of an electrical energy storage system 102 comprising multiple electrical energy storage packs 104 connectable to a voltage bus 110 for providing power to an electric load 112; determine a subset of at least one of electrical energy storage pack that can be disconnected from the voltage bus 110 without violating present power requirements for the electric load, wherein the following steps are repeated for each subset of at least one electrical energy storage pack until an isolation fault is detected in an electrical energy storage pack 104 of the electrical energy storage system 102, or until all subsets of at least one electrical energy storage pack have been tested: disconnect a present subset of at least one the electrical energy storage pack from the voltage bus, perform isolation fault check on the disconnected subset of at least one electrical energy storage pack while the other subsets of at least one electrical energy storage pack remain connected to the voltage bus, and provide a control message indicating the outcome of the isolation fault test.

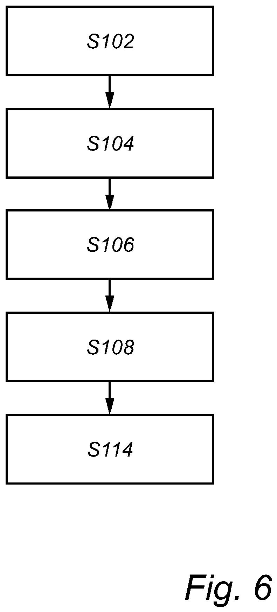

**FIG. 6** is a flow chart of a method to perform isolation testing of an electrical energy storage system according to an example.

In step S102 detecting, by processing circuitry of a computer system, an isolation fault of an electrical energy storage system comprising multiple electrical energy storage packs connectable to a voltage bus for providing power to an electric load.

In step S104, determining, by the processing circuitry, a subset of at least one of electrical energy storage pack that can be disconnected from the voltage bus without violating present power requirements/need for the electric load, wherein the following steps are repeated for each subset of at least one electrical energy storage pack until an isolation fault is detected in an electrical energy storage pack of the electrical energy storage system, or until all subsets of at least one electrical energy storage pack have been tested:
In step S106, disconnecting, by the processing circuitry, a present subset of at least one electrical energy storage pack from the voltage bus.

In step S108, performing, by the processing circuitry, isolation fault check on the disconnected subset of at least one electrical energy storage pack while the other subset(s) of at least one electrical energy storage pack remain connected to the voltage bus,

In step S114, providing, by the processing circuitry, a control message indicating the outcome of the isolation fault test.

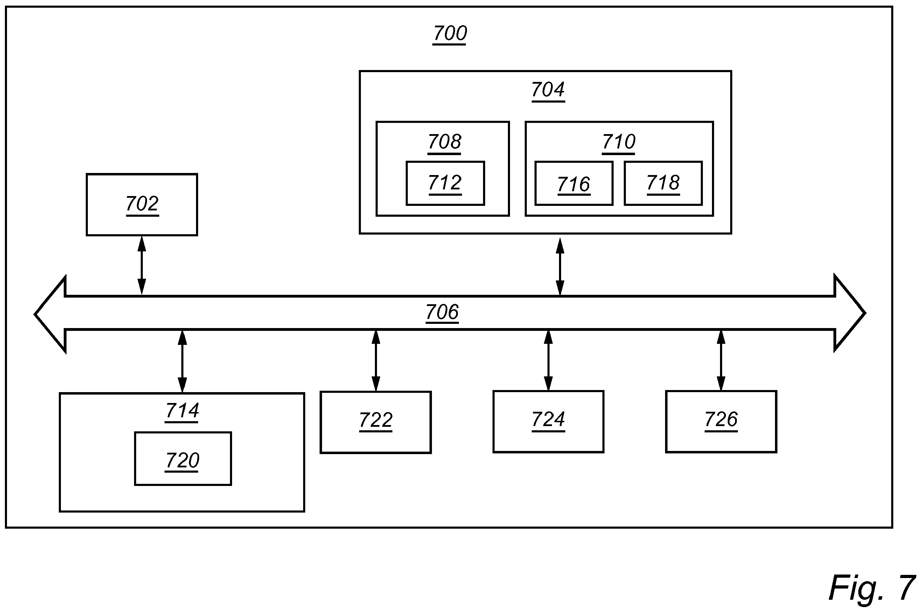

**FIG. 7** is a schematic diagram of a computer system **700** for implementing examples disclosed herein. The computer system **700** is adapted to execute instructions from a computer-readable medium to perform these and/or any of the functions or processing described herein. The computer system **700** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **700** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **700** may comprise at least one computing device or electronic device capable of including firmware, hardware, and/or executing software instructions to implement the functionality described herein. The computer system **700** may include processing circuitry **702** (e.g., processing circuitry including one or more processor devices or control units), a memory **704**, and a system bus **706.** The computer system **700** may include at least one computing device having the processing circuitry **702.** The system bus **708** provides an interface for system components including, but not limited to, the memory **704** and the processing circuitry **702.** The processing circuitry **702** may include any number of hardware components for conducting data or signal processing or for executing computer code stored in memory **704.** The processing circuitry **702** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **702** may further include computer executable code that controls operation of the programmable device.

The system bus **706** may be any of several types of bus structures that may further interconnect to a memory bus (with or without a memory controller), a peripheral bus, and/or a local bus using any of a variety of bus architectures. The memory **704** may be one or more devices for storing data and/or computer code for completing or facilitating methods described herein. The memory **704** may include database components, object code components, script components, or other types of information structure for supporting the various activities herein. Any distributed or local memory device may be utilized with the systems and methods of this description. The memory **704** may be communicably connected to the processing circuitry **702** (e.g., via a circuit or any other wired, wireless, or network connection) and may include computer code for executing one or more processes described herein. The memory **704** may include non-volatile memory **708** (e.g., read-only memory (ROM), erasable programmable read-only memory (EPROM), electrically erasable programmable read-only memory (EEPROM), etc.), and volatile memory **710** (e.g., random-access memory (RAM)), or any other medium which can be used to carry or store desired program code in the form of machine-executable instructions or data structures and which can be accessed by a computer or other machine with processing circuitry **702.** A basic input/output system (BIOS) **712** may be stored in the non-volatile memory **708** and can include the basic routines that help to transfer information between elements within the computer system **700.**

The computer system **700** may further include or be coupled to a non-transitory computer-readable storage medium such as the storage device **714**, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **714** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **714** and/or in the volatile memory **710**, which may include an operating system **716** and/or one or more program modules **718.** All or a portion of the examples disclosed herein may be implemented as a computer program **720** stored on a transitory or non-transitory computer-usable or computer-readable storage medium (e.g., single medium or multiple media), such as the storage device **714**, which includes complex programming instructions (e.g., complex computer-readable program code) to cause the processing circuitry **702** to carry out actions described herein. Thus, the computer-readable program code of the computer program **720** can comprise software instructions for implementing the functionality of the examples described herein when executed by the processing circuitry **702.** In some examples, the storage device **714** may be a computer program product (e.g., readable storage medium) storing the computer program **720** thereon, where at least a portion of a computer program **720** may be loadable (e.g., into a processor) for implementing the functionality of the examples described herein when executed by the processing circuitry **702.** The processing circuitry **702** may serve as a controller or control system for the computer system **700** that is to implement the functionality described herein.

The computer system **700** may include an input device interface **722** configured to receive input and selections to be communicated to the computer system **700** when executing instructions, such as from a keyboard, mouse, touch-sensitive surface, etc. Such input devices may be connected to the processing circuitry **702** through the input device
interface **722** coupled to the system bus **706** but can be connected through other interfaces, such as a parallel port, an Institute of Electrical and Electronic Engineers (IEEE) 1394 serial port, a Universal Serial Bus (USB) port, an IR interface, and the like. The computer system **700** may include an output device interface **724** configured to forward output, such as to a display, a video display unit (e.g., a liquid crystal display (LCD) or a cathode ray tube (CRT)). The computer system **700** may include a communications interface **726** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to: detect an isolation fault of an electrical energy storage system comprising multiple electrical energy storage packs connectable to a voltage bus for providing power to an electric load; determine a subset of at least one of electrical energy storage pack that can be disconnected from the voltage bus without violating present power requirements for the electric load, wherein the following steps are repeated for each subset of at least one electrical energy storage pack until an isolation fault is detected in an electrical energy storage pack of the electrical energy storage system, or until all subsets of at least one electrical energy storage pack have been tested: disconnect a present subset of at least one electrical energy storage pack from the voltage bus; perform isolation fault check on the disconnected subset of at least one electrical energy storage pack while the other subset(s) of at least one electrical energy storage pack are connected to the voltage bus, and provide a control message indicating the outcome of the isolation fault test.

Example 2: The computer system of example 1, wherein the processing circuitry is further configured to: determine an electrical energy storage state for each of the subsets, and determine the order of disconnecting the subsets based on the determined electrical energy storage states.

Example 3: The computer system of example 2, wherein the electrical energy storage state is one of state of charge and state of health.

Example 4: The computer system of any of example 2-3, wherein the processing circuitry is further configured to: disconnect the subsets in the order of falling amount of available energy in the subsets determined from the electrical energy storage state.

Example 5: The computer system of any of examples 1-4, wherein the processing circuitry is further configured to: if an isolation fault is detected in one electrical energy storage pack in the one subset of electrical energy storage pack, setting the one electrical energy storage pack in an error state, if no isolation fault is detected in one electrical energy storage pack in the one subset of electrical energy storage packs, re-connecting the one electrical energy storage pack to the voltage bus.

Example 6: The computer system of any of examples 1-5, wherein the processing circuitry is further configured to: disconnect the present subset from the voltage bus and perform isolation fault tests while the remaining electrical energy storage packs provide energy/power to the electric load.

Example 7: The computer system of any of examples 1-6, wherein the subset comprises more than one electrical energy storage pack.

Example 8: The computer system of example 1, wherein the processing circuitry is further configured to: determine an electrical energy storage state for each multiple of the subsets of electrical energy storage packs; determine the order of disconnecting the subsets of electrical energy storage packs based on the relative magnitude of the electrical energy storage states, wherein the following steps are repeated for the subsets of electrical energy storage packs in the determined order: disconnecting one of the subsets of electrical energy storage packs from the voltage bus; perform isolation check on the disconnected subset of electrical energy storage packs while the other subsets of electrical energy storage packs are connected to the voltage bus; if an isolation fault is detected in the one electrical energy storage pack, setting one electrical energy storage pack in an error state, if no isolation fault is detected in the one electrical energy storage pack, re-connecting the one electrical energy storage pack to the voltage bus.

Example 9: An electrical energy storage system comprising the computer system of any of examples 1-8.

Example 10: A vehicle comprising the electrical energy storage system of example 9.

Example 11: A computer-implemented method, comprising: detecting, by processing circuitry of a computer system, an isolation fault of an electrical energy storage system comprising multiple electrical energy storage packs connectable to a voltage bus for providing power to an electric load; determining, by the processing circuitry, a subset of at least one of electrical energy storage pack that can be disconnected from the voltage bus without violating present power requirements/need for the electric load, wherein the following steps are repeated for each subset of at least one electrical energy storage pack until an isolation fault is detected in an electrical energy storage pack of the electrical energy storage system, or until all subsets of at least one electrical energy storage pack have been tested: disconnecting, by the processing circuitry, a present subset of at least one electrical energy storage pack from the voltage bus; performing, by the processing circuitry, isolation fault check on the disconnected subset of at least one electrical energy storage pack while the other subset(s) of at least one electrical energy storage pack remain connected to the voltage bus, providing, by the processing circuitry, a control message indicating the outcome of the isolation fault test.

Example 12: The method of example 11, comprising: determining, by the processing circuitry, an electrical energy storage state for each of the subsets, and determining, by the processing circuitry, the order of disconnecting the subsets based on the determined electrical energy storage states.

Example 13: The method of example 12, wherein the electrical energy storage state is one of state of charge and state of health.

Example 14: The method of any of example 12-13, comprising: disconnecting, by the processing circuitry, the subsets in the order of falling amount of available energy in the subsets determined from the electrical energy storage state.

Example 15: The method of any of examples 11-14, comprising: detecting, by the processing circuitry, an isolation fault in one electrical energy storage pack in the one subset, and setting, by the processing circuitry, the one electrical energy storage pack in an error state.

Example 16: The method of any of examples 11-15, comprising: determining, by the processing circuitry, that no isolation fault is detected in the one electrical energy storage pack in the subset, and re-connecting, by the processing circuitry, the one electrical energy storage pack to the voltage bus.

Example 17: The method of examples 11-16, comprising: disconnecting, by the processing circuitry, the present subset from the voltage bus and perform isolation fault tests while the remaining electrical energy storage packs provide energy/power to the electric load.

Example 18: The method of any of examples 11-17, wherein the subset comprises more than one electrical energy storage pack.

Example 19: The method of example 11, comprising: determining, by the processing circuitry, an electrical energy storage state for each multiple of the subsets of electrical energy storage packs; determining, by the processing circuitry, the order of disconnecting the subsets of at least one electrical energy storage pack based on the relative magnitude of the electrical energy storage states, wherein the following steps are repeated for the subsets of at least one electrical energy storage packs in the determined order: disconnecting, by the processing circuitry, one of the subsets of at least one electrical energy storage packs from the voltage bus; performing, by the processing circuitry, an isolation check on the disconnected subset of at least one electrical energy storage packs while the other subsets of electrical energy storage packs reamian connected to the voltage bus; if an isolation fault is detected in the one electrical energy storage pack, setting, by the processing circuitry, the one electrical energy storage pack in an error state, if no isolation fault is detected in the one electrical energy storage pack, re-connecting, by the processing circuitry, the one electrical energy storage pack to the voltage bus.

Example 20: The method of example 11, detect an isolation fault of an electrical energy storage system may comprise: determining, by the processing circuitry, an isolation level to a traction system for the electrical energy storage system, and determine that an isolation fault is present based on the isolation level.

Example 21: A computer program product comprising program code for performing, when executed by the processing circuitry, the method of any of examples 11-20.

Example 22: A non-transitory computer-readable storage medium comprising instructions, which when executed by the processing circuitry, cause the processing circuitry to perform the method of any of examples 11-20.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (106) comprising processing circuitry (108) configured to:
detect an isolation fault of an electrical energy storage system (102) comprising multiple electrical energy storage packs (104) connectable to a voltage bus (110) for providing power to an electric load (112);
determine a subset (124) of at least one of electrical energy storage pack that can be disconnected from the voltage bus (110) without violating present power requirements for the electric load,
wherein the following steps are repeated for each subset of at least one electrical energy storage pack until an isolation fault is detected in an electrical energy storage pack (104) of the electrical energy storage system (102), or until all subsets of at least one electrical energy storage pack have been tested:
disconnect a present subset of at least one electrical energy storage pack from the voltage bus;
perform isolation fault check on the disconnected subset of at least one electrical energy storage pack while the other subsets of at least one electrical energy storage pack remain connected to the voltage bus, and
provide a control message indicating the outcome of the isolation fault test.

2. The computer system of claim 1, wherein the processing circuitry is further configured to:
determine an electrical energy storage state for each of the subsets, and
determine the order of disconnecting the subsets based on the determined electrical energy storage states.

3. The computer system of claim 2, wherein the electrical energy storage state is one of state of charge and state of health.

4. The computer system of any of claim 2-3, wherein the processing circuitry is further configured to:
disconnect the subsets in the order of falling amount of available energy in the subsets determined from the electrical energy storage state.

5. The computer system of any of claims 1-4, wherein the processing circuitry is further configured to:
if an isolation fault is detected in one electrical energy storage pack in the one subset of at least one electrical energy storage pack, setting the one electrical energy storage pack in an error state,
if no isolation fault is detected in one electrical energy storage pack in the one subset of electrical energy storage packs, re-connecting the one electrical energy storage pack to the voltage bus.

6. The computer system of any of claims 1-5, wherein the processing circuitry is further configured to:
disconnect the present subset from the voltage bus and perform isolation fault tests while the remaining electrical energy storage packs provide energy to the electric load.

7. The computer system of any of claims 1-6, wherein the subset comprises more than one electrical energy storage pack.

8. The computer system of claim 1, wherein the processing circuitry is further configured to:
determine an electrical energy storage state for each multiple of the subsets of electrical energy storage packs;
determine the order of disconnecting the subsets of electrical energy storage packs based on the relative magnitude of the electrical energy storage states,
wherein the following steps are repeated for the subsets of electrical energy storage packs in the determined order:
disconnecting one of the subsets of electrical energy storage packs from the voltage bus;
perform isolation check on the disconnected subset of electrical energy storage packs while the other subsets of electrical energy storage packs remain connected to the voltage bus;
if an isolation fault is detected in one electrical energy storage pack in the subset, setting the one electrical energy storage pack in an error state,
if no isolation fault is detected in the one electrical energy storage pack, re-connecting the one electrical energy storage pack to the voltage bus.

9. An electrical energy storage system comprising the computer system of any of claims 1-8.

10. A vehicle (100) comprising the electrical energy storage system of claim 9.

11. A computer-implemented method, comprising:
detecting (S102), by processing circuitry of a computer system, an isolation fault of an electrical energy storage system comprising multiple electrical energy storage packs connectable to a voltage bus for providing power to an electric load;
determining (S104), by the processing circuitry, a subset of at least one of electrical energy storage pack that can be disconnected from the voltage bus without violating present power requirements/need for the electric load,
wherein the following steps are repeated for each subset of at least one electrical energy storage pack until an isolation fault is detected in an electrical energy storage pack of the electrical energy storage system, or until all subsets of at least one electrical energy storage pack have been tested:
disconnecting (S106), by the processing circuitry, a present subset of the at least one electrical energy storage pack from the voltage bus;
performing (S108), by the processing circuitry, isolation fault check on the disconnected subset of at least one electrical energy storage pack while the other subsets of at least one electrical energy storage pack remain connected to the voltage bus,
providing (S114), by the processing circuitry, a control message indicating the outcome of the isolation fault test.

12. The method of claim 11, comprising:
detecting, by the processing circuitry, an isolation fault in one electrical energy storage pack in the one subset, and
setting, by the processing circuitry, the one electrical energy storage pack in an error state.

13. The method of any of claims 11-12, comprising:
determining, by the processing circuitry, that no isolation fault is detected in one electrical energy storage pack in the one subset, and
re-connecting, by the processing circuitry, the one electrical energy storage pack to the voltage bus.

14. A computer program product comprising program code for performing, when executed by the processing circuitry, the method of any of claims 11-13.

15. A non-transitory computer-readable storage medium comprising instructions, which when executed by the processing circuitry, cause the processing circuitry to perform the method of any of claims 11-13.
